Europäisches Patentamt

European Patent Office

Office européen des brevets

(11) Publication number: **0 376 063**
**A2**

## EUROPEAN PATENT APPLICATION

(21) Application number: **89123046.8**

(22) Date of filing: **13.12.89**

(51) Int. Cl.⁵: **G06F 15/78**

(30) Priority: **28.12.88 JP 328921/88**

(43) Date of publication of application:
**04.07.90 Bulletin 90/27**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Wada, Yukio c/o Intellectual**
**Property Division**
**K.K. Toshiba 1-1 Shibaura 1-chome**
**Minato-ku Tokyo 105(JP)**
Inventor: **Maruyama, Tadashi c/o Intellectual**
**Property Divisi**
**K.K. Toshiba 1-1 Shibaura 1-chome**
**Minato-ku Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) **Programmable single-chip microcomputer.**

(57) A single-chip microcomputer comprises a logical circuit (21), a batch ultraviolet erasure type non-volatile memory (22), and an electrically writable/erasable non-volatile memory (23), and the logical circuit (21), the batch ultraviolet erasure type non-volatile memory (22) and the electrically writable/erasable non-volatile memory (23) are integrated on a single semiconductor chip (20). A program necessary for data processing in the single-chip microcomputer is stored in the batch ultraviolet erasure type non-volatile memory (22), and various data units are stored in the electrically writable/erasable non-volatile memory (23). Thus, the program can be easily rewritten, and data erasure due to a power supply abnormality can be prevented.

F I G. 2

## Programmable single-chip microcomputer

The present invention relates generally to a single-chip microcomputer, and in particular to a single-chip microcomputer serving as a data carrier such as an IC card, or mounted in various electric devices.

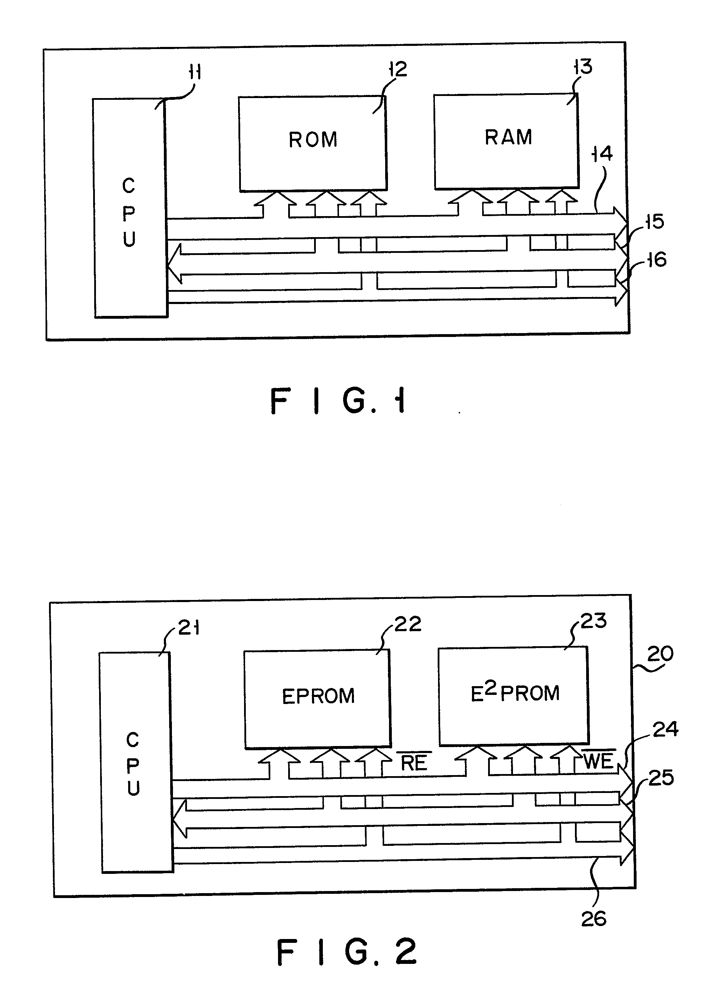

Fig. 1 shows a typical conventional single-chip microcomputer. This single-chip computer comprises a central processing unit (CPU) 11, a read-only memory (ROM) 12, and a random-access memory (RAM) 13. The CPU 11 is connected to the ROM 12 and the RAM 13 through a system bus including an address bus 14, a data bus 15 and a control bus 16. The ROM 12 stores various programs such as an operating system for controlling the data processing operation of the CPU 11. The RAM 13 stores various data units to be processed by the CPU 11.

This type of conventional single-chip microcomputer has the following problems.

First, since the operating system is stored in the ROM 12, the contents of the programs therein cannot be changed easily. In particular, in a microcomputer used for controlling a portable calculator, a camera, an air-conditioner, etc., the operating system used therein often needs to be changed due to changes in specifications. Thus, the conventional single-chip microcomputer wherein the program cannot be rewritten is unsuitable for these electric devices.

Secondly, since data is stored in the RAM 13, there is a concern that the stored data may be lost owing to power supply abnormalities such as power failure or power shortage in the batteries. This problem is very serious in a battery-powered device such as an IC card. In the single-chip microcomputer, in order to prevent the stored data from being lost, it is necessary to use a backup system or an auxiliary memory device, resulting in an increase in the chip area of the microcomputer and a rise in manufacturing costs.

Also, since an instruction decoder in the CPU 11 is normally constituted by a ROM, it is not possible to change the program in the instruction decoder. Consequently, a great deal of time and cost is required to develop a CPU having a new architecture. Since the CPU 11 of the single-chip microcomputer functions only as a general-purpose CPU, there may be many unnecessary functions or there may be no necessary functions, depending on the purpose for which the microcomputer is used.

Furthermore, the conventional CPU 11 having a fixed architecture is not applicable to a microcomputer having a learning function, as represented by artificial intelligence or neural network.

The object of the present invention is to provide a single-chip microcomputer wherein the program contents can be easily changed, and stored data can be surely protected against power supply abnormalities.

The present invention provides a single-chip microcomputer comprising a logic circuit, a batch ultraviolet erasure type non-volatile memory, and an electrically writable/erasable non-volatile memory, which are all formed on a single chip.

In this microcomputer, a program is stored in the batch ultraviolet erasure type non-volatile memory, and various data units are stored in the electrically writable/erasable non-volatile memory. Thus, the program can be changed easily, and stored data can be protected against power supply abnormalities.

This invention can be more fully understood from the following detailed description when taken in conjunction with the accompanying drawings, in which:

Fig. 1 is a block diagram showing a conventional single-chip microcomputer;

Fig. 2 is a block diagram showing a single-chip microcomputer according to an embodiment of the present invention;

Fig. 3 is a block diagram showing an example of the structure of a CPU mounted in the single-chip microcomputer shown in Fig. 2; and

Fig. 4 is a block diagram showing another example of the structure of the CPU mounted in the single-chip microcomputer shown in Fig. 2.

Fig. 2 shows a single-chip microcomputer according to an embodiment of the present invention. This microcomputer is integrated on a semiconductor chip 20 and comprises a CPU 21, a batch ultraviolet erasure type non-volatile memory or an erasable programmable read-only memory (EPROM) 22, an electrically writable/erasable non-volatile memory or an electrically erasable programmable read-only memory (EEPROM) 23, an address bus 24, a data bus 25 and a control bus 26. The CPU 21, EPROM 22 and EEPROM 23 are mutually connected by the address bus 24, data bus 25 and control bus 26.

The EPROM 22 stores a basic program for controlling the operation of the CPU 21, and the EEPROM 23 stores various data units to be processed by the CPU 21.

The basic operation of this single-chip microcomputer will now be described. First, the CPU 21 accesses the EPROM 22 to determine what operation should be done next. In other words, the CPU 21 supplies a predetermined address to the EPROM 22 through the address bus 24, and lowers the level of a readout enable signal $\overline{RE}$ which flows through a control signal line in the control bus 26. Thus, the EPROM 22 is read-accessed by the CPU 21, and the data corresponding to the designated address is read out from the EPROM 22 to the data bus 25. When the level of the readout enable signal RE rises, the CPU 21 reads the data on the data bus 25, and executes the processing corresponding to the read data.

For instance, when the read data is an instruction to write in the EEPROM 23, the CPU 21 supplies to the address bus 24 an address representative of the write location in the EEPROM 23, and outputs to the data bus 25 data to be written in. Then, the CPU 21 lowers the level of a write enable signal WE which flows through a control signal line in the control bus 26. Thus, the EEPROM 23 is write-accessed by the CPU 21. When the level of the write enable signal WE falls, data is written at the designated address in the EEPROM 23.

In the above-described single-chip microcomputer, a program is stored in the EPROM 22. The program is erased by means of ultraviolet light, and a new program can be electrically written in the EPROM 22. In addition, since data is stored in the EEPROM 23 serving as a non-volatile memory, rather than a RAM, data erasure due to power supply abnormalities such as power failure or a power shortage in the battery can be prevented.

Since the single-chip microcomputer according to this embodiment allows easy rewriting of the program, this microcomputer can be used for controlling electric devices such as portable calculators, cameras, air-conditioners, etc., the specifications of which often need to be changed. Further, in this single-chip microcomputer, because data protection can be ensured with a simple structure, rather than using a backup system or the like, no increase in chip size and cost is involved.

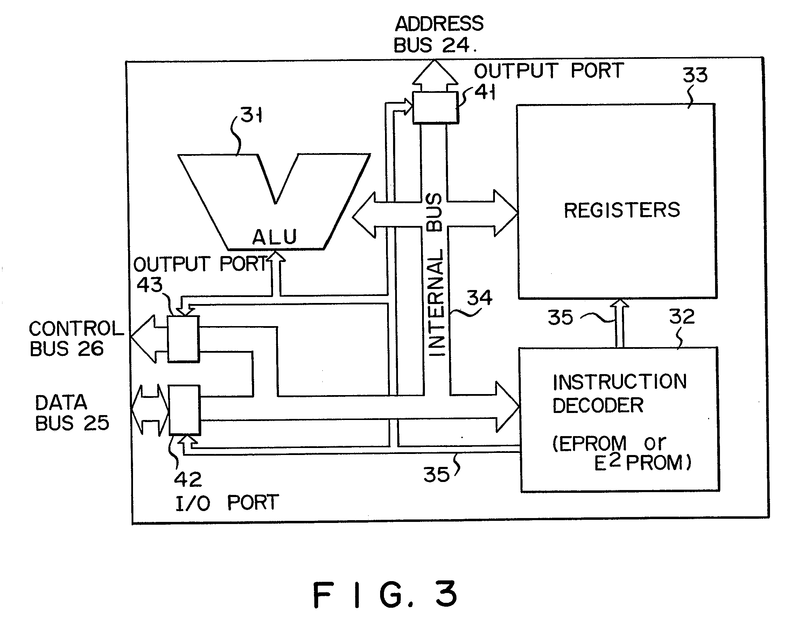

Fig. 3 shows an example of a specific structure of the CPU 21. The CPU 21 comprises an arithmetic logical operation unit (ALU) 31, an instruction decoder 32, various registers 33, an internal bus 34, an internal control bus 35, output ports 41 and 43, and an input/output (I/O) port 42. The ALU 31, instruction decoder 32 and various decoders 33 are mutually connected by the internal bus 34. The internal control bus 35 serves to transmit a drive control signal output from the instruction decoder 32 to the ALU 31 and various registers 33, and also serves to transmit an I/O control signal output from the instruction decoder 32 to the I/O port 42 and output ports 41 and 43. The I/O port 42 controls the transmission/reception of data between the data bus 25 and the internal bus 34 in accordance with the I/O control signal output from the instruction decoder 32. The output port 41 controls the transmission of an address from the internal bus 34 to the address bus 24 in accordance with the I/O control signal output from the instruction decoder 32. The output port 43 controls the transmission of an address from the internal bus 34 to the control bus 26 in accordance with the I/O control signal output from the instruction decoder 32.

The instruction decoder 32 is constituted by an EPROM or an EEPROM. Thus, it is possible for a user to change the program stored in the instruction decoder 32 to form a CPU corresponding to new specifications in a short time and at a low cost.

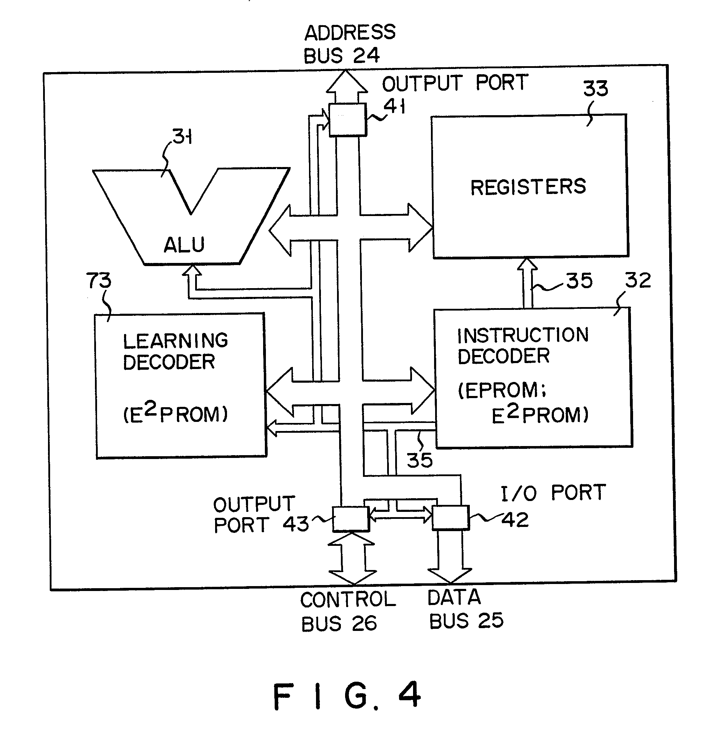

Fig. 4 shows another example of a specific structure of the CPU 21. This CPU 21 is designed to suitably perform a learning function. The CPU 21 of this example has a self-programmable decoder (learning decoder) 73, in addition to the structural components shown in Fig. 3. The learning decoder 73 is constituted by an EEPROM, and has a function for changing logical data stored therein in accordance with analyzed results. The learning decoder 73 is controlled by the drive control signal supplied from the instruction decoder 32 through the internal control bus 35.

The learning decoder 32 stores learning algorithms. The programs stored in the learning decoder 32 are changed in accordance with an instruction from the instruction decoder 32.

Thus, the structure of the CPU 21 shown in Fig. 4 is suitable for constituting a microcomputer having a learning function, as represented by artificial intelligence or neural network.

As has been described above, the present invention can realize a single-chip microcomputer wherein programs can be easily rewritten and data protection can be ensured.

Reference signs in the claims are intended for better understanding and shall not limit the scope.

## Claims

1. A single-chip microcomputer integrated on a single semiconductor chip (20) characterized by comprising:
a logical circuit (21);
a batch ultraviolet erasure type non-volatile memory (22); and
an electrically writable/erasable non-volatile memory (23),
wherein said single-chip microcomputer executes data processing in accordance with a program stored in said batch ultraviolet erasure type non-volatile memory (22).

2. The single-chip microcomputer according to claim 1, characterized in that said logic circuit (21) includes a central processing unit, said batch ultraviolet erasure type non-volatile memory (22) stores a program for controlling the operation of said central processing unit, said electrically writable/erasable non-volatile memory stores various data units to be processed by said central processing unit, and said central processing unit is connected to the batch ultraviolet erasure type non-volatile memory (22) and the electrically writable/erasable non-volatile memory (23) through a system bus (24, 25, 26).

3. The single-chip microcomputer according to claim 2, characterized in that said central processing unit comprises an arithmetic logical operation unit (31), registers (33) and an instruction decoder (32), and said instruction decoder (32) is constituted by a batch ultraviolet erasure type non-volatile memory.

4. The single-chip microcomputer according to claim 2, characterized in that said central processing unit comprises an arithmetic logical operation unit (31), registers (33) and an instruction decoder (32), and said instruction decoder (32) is constituted by an electrically writable/erasable non-volatile memory.

5. The single-chip microcomputer according to claim 2, characterized in that said central processing unit comprises an arithmetic logical operation unit (31), registers (33), an instruction decoder (32), and a self-programmable learning decoder (73), and said learning decoder (73) is constituted by an electrically writable/erasable non-volatile memory.

6. The single-chip microcomputer according to claim 5, characterized in that said instruction decoder (32) has a learning algorithm function for changing a program stored in the learning decoder (73).

F I G. 1

F I G. 2

F I G. 3

EP 0 376 063 A2

ADDRESS
BUS 24

OUTPUT PORT

41

33

31

REGISTERS

ALU

73

35

32

LEARNING
DECODER

(E$^2$PROM)

INSTRUCTION
DECODER

(EPROM;
E$^2$PROM)

35

OUTPUT
PORT 43

I/O PORT

42

CONTROL
BUS 26

DATA
BUS 25

F I G. 4